# EUROPEAN PATENT SPECIFICATION

(11) **EP 3 678 367 B1**
(45) Date of publication and mention of the grant of the patent: **13.12.2023**
(21) Application number: 17923117.0
(22) Date of filing: 28.08.2017
(51) Int. Cl.: G02F 1/1333, G06F 1/16, H10K 50/00, H10K 59/10, H04N 5/645, H04N 5/655, H04N 5/65

(54) **DISPLAY DEVICE**
ANZEIGEVORRICHTUNG
DISPOSITIF D'AFFICHAGE

(43) Date of publication of application: 08.07.2020
(73) Proprietor: LG Electronics Inc., Seoul 07336 (KR)
(72) Inventor: RYU, Jaeuk, Seoul 06772 (KR); CHOI, Woohyuk, Seoul 06772 (KR); KIM, Jaekun, Seoul 06772 (KR); KIM, Junhyung, Seoul 06772 (KR); BAEK, Manin, Seoul 06772 (KR); LEE, Bosung, Seoul 06772 (KR)
(74) Representative: Frenkel, Matthias Alexander
(86) International application number: PCT/KR2017/009380
(87) International publication number: WO 2019/045124

(56) References cited:
- KR-A- 20110 062 786
- KR-A- 20150 066 021
- KR-A- 20150 066 021
- KR-A- 20160 070 941
- KR-B1- 101 472 340
- KR-B1- 101 577 336
- US-A1- 2013 170 116
- US-A1- 2014 092 631
- US-A1- 2016 120 043

## Description

### [Technical Field]

The present invention relates to a display device. More particularly, the present invention relates to a display device having a module cover coupled to the display panel which provide the display panel with rigidity.

### [Background Art]

As the information society develops, the demand for display devices has been increased in various forms. The display can be implemented by using an LCD (Liquid Crystal Display Device), a PDP (Plasma Display Panel), an ELD (Electroluminescent Display), a VFD (Vacuum Fluorescent Display), and an OLED (Organic Light Emitting Diode).

Recently, research has been conducted on a display device having a structure attached to the rear surface of a display panel to provide rigidity to the display panel.

Relevant background art, which can be regarded as useful for understanding the invention, includes: US 2016/120043 A1, KR 101472340 B1, KR 101577336 B1, KR 20150066021 A.

### [Disclosure]

### [Technical Problem]

Accordingly, an object of the present disclosure is to address the above-described and other problems.

Another object of the present invention may be to reduce the thickness of the display device.

Another object of the present invention may be to make the bezel of the display device slimmer.

Another object of the present invention may be to reduce the weight of the display device.

Another object of the present invention is to provide a display device having a structure for stably protecting a display panel.

Another object of the present invention is to improve the rigidity of the display device.

Another object of the present invention may be to simplify the manufacturing process of the display device.

Another object of the present invention may be to reduce the manufacturing cost of the display device.

### [Technical Solution]

The device according to the present invention comprises the features of claim 1. Preferred embodiments are disclosed in the dependent claims.

According to an embodiment of the present invention, a heat expansion coefficient of the flat plate portion first layer may be greater than a heat expansion coefficient of the flat plate portion second layer, a heat expansion coefficient of the flat plate portion third layer may be greater than the heat expansion coefficient of the flat plate portion second layer, and the heat expansion coefficient of the flat plate portion first layer may be same as the heat expansion coefficient of the third layer.

### [Advantageous Effects]

According to at least one embodiment of the present invention, relatively thin display device may be provided.

According to at least one embodiment of the present invention, the display device having slim bezel may be provided.

According to at least one embodiment of the present invention, the display device having light weight may be provided.

According to at least one embodiment of the present invention, a display device having a structure for stably protecting a display panel may be provided.

According to at least one embodiment of the present invention, the rigidity of the display device may be improved.

According to at least one embodiment of the present invention, the manufacturing process of the display device may be simplified.

According to at least one embodiment of the present invention, the manufacturing cost of the display device may be reduced.

### [Description of Drawings]

FIGS. 1 to 5 are views showing a display device according to various embodiments of the present invention.
FIGS. 6 to 13 are views showing, in accordance with various embodiments of the present invention, a cross-section of the display unit of FIG 1 taken along the line A1-A2.
FIGS. 14 to 23 are views illustrating a module cover according to various embodiments of the present invention.

### [Mode for Invention]

Hereinafter, exemplary embodiments disclosed herein will be described in detail with reference to the accompanying drawings, but the same or similar elements will be assigned the same reference numbers regardless of the reference numerals, and redundant descriptions thereof will be omitted.

The suffixes "modules" and "parts" for components used in the following description are given or mixed in consideration of the ease of writing the specification, and do not have meanings or roles that are distinct from each other. In addition, in describing the embodiments disclosed in the present specification, detailed descriptions of related well-known technologies are omitted when it is determined that the gist of the embodiments disclosed in the present specification may be obscured. In addition, the accompanying drawings are only for easy understanding of the embodiments disclosed in the present specification, and the technical content disclosed in the specification is not limited by the accompanying drawings.

The terms "first," "second," etc. may be used to describe various components, but the components are not limited by such terms. The terms are used only for the purpose of distinguishing one component from other components.

When an arbitrary component is described as "being connected to" or "being linked to" another component, this should be understood to mean that still another component(s) may exist between them, although the arbitrary component may be directly connected to, or linked to, the second component. In contrast, when an arbitrary component is described as "being directly connected to" or "being directly linked to" another component, this should be understood to mean that no component exists between them.

A singular expression can include a plural expression as long as it does not have an apparently different meaning in context.

In the present application, the terms "include" and "have" should be understood to be intended to designate that illustrated features, numbers, steps, operations, components, parts or combinations thereof exist and not to preclude the existence of one or more different features, numbers, steps, operations, components, parts or combinations thereof, or the possibility of the addition thereof.

The display panel applicable to the present invention may be an organic light emitting diode panel (OLED panel), a plasma display panel (PDP), a field emission display panel (FED panel), and a liquid crystal panel (LCD panel).

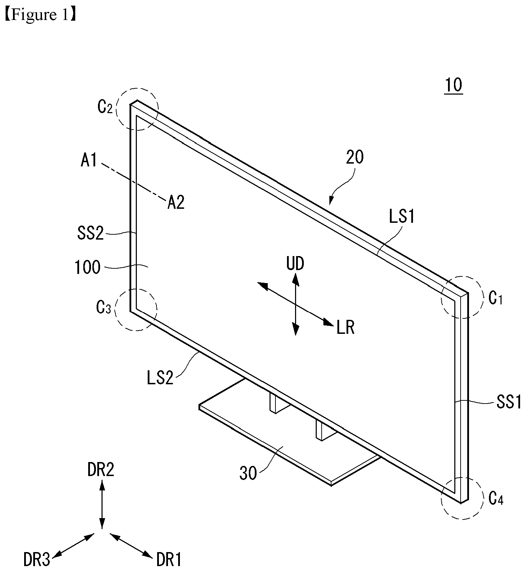

Referring to FIG. 1, the display device 10 includes a display unit 20 and may include a pedestal 30. The display unit 20 may have a planar shape as a whole. The pedestal 30 may extend downward from the display unit 20. The pedestal 30 can support the display unit 20.

The display unit 20 may include a first long side LS1 and a second long side LS2 opposite to the first long side LS1. The display unit 20 may include a first short side SS1 and a second short side SS2 opposite to the first short side S S 1. The first short side SS1 may be adjacent to both the first long side LS1 and the second long side LS2.

An area adjacent to the first short side SS1 may be referred to as a first short side area SS1. An area adjacent to the second short side SS2 may be referred to as a second short side area SS2. An area adjacent to the first long side LS1 may be referred to as a first long side area LS1. An area adjacent to the second long side LS2 may be referred to as a second long side area LS2.

The first short side area SS1 may be referred to as a first side area. The second short side area SS2 may be referred to as a second side area. The first long side area LS1 may be referred to as a third side area. The second long side area LS2 may be referred to as a fourth side area.

The lengths of the first and second long sides LS1 and LS2 may be longer than the lengths of the first and second short sides SS1 and SS2 for the convenience of explanation. It is also possible that the lengths of the first and second long sides LS1 and LS2 are substantially equal to the lengths of the first and second short sides SS1 and SS2.

The display unit 20 may include a display panel 100 for displaying an image. The display panel 100 may form a front surface of the display unit 20. The display panel 100 can display an image toward the front of the display unit 20.

The first direction DR1 may be a direction along to the long sides LS1 and LS2 of the display unit 20. The second direction DR2 may be a direction along to the short sides SS1 and SS2 of the display unit 20.

The third direction DR3 may be a direction normal to the first direction DR1 and / or the second direction DR2.

The first direction DR1 may be referred to as a horizontal direction. The first direction DR1 may be a virtual horizontal axis. The second direction DR2 may be referred to as a vertical direction. The second direction DR2 may be a virtual vertical axis. The third direction DR3 may be a back-and-forth direction. The third direction DR3 may be another virtual horizontal axis.

A side on which the display unit 20 displays the image may be referred to as a 'forward direction' or a 'front side' of the display unit 20. A side on which the image cannot be viewed may be referred to as a 'rearward direction' or a 'rear side' of the display unit 20.

From the viewpoint of the front side of the display unit 20, the first long side LS1 may be referred to as an upper side or an upper surface, the second long side LS2 side may be referred to as a lower side or a lower surface, the first short side SS1 may be referred to as a right side or the right side, and the second short side SS2 may be referred to as a left side or a left side.

The first long side LS1, the second long side LS2, the first short side SS1 and the second short side SS2 may be referred to as an edge of the display unit 20. The area where the first long side LS1, the second long side LS2, the first short side SS1, and the second short side SS2 meet with each other may be referred to as a corner. For example, the area where the first long side LS1 and the first short side SS1 meet may be referred to as a first corner C1. The area where the first long side LS1 and the second short side SS2 meet may be referred to as a second corner C2. The area where the second short side SS2 and the second long side LS2 meet may be referred to as a third corner C3. The area where the second long side LS2 and the first short side SS1 meet may be referred to as a fourth corner C4.

The direction from the first short side SS1 to the second short side SS2 or the direction from the second short side SS2 to the first short side SS1 may be referred to as the left and right direction LR. The direction from the first long side LS1 to the second long side LS2 or the direction from the second long side LS2 to the first long side LS1 may be referred to as the up and down direction UD.

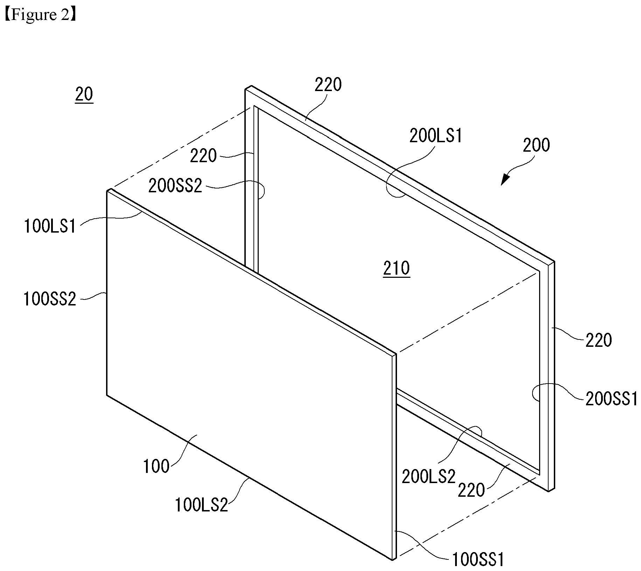

Referring to FIG. 2, the module cover 200 includes a flat plate portion 210 and a side wall 220. The module cover 200 is disposed behind the display panel 100. The module cover 200 may be attached to the display panel 100. The flat plate portion 210 may be referred to as a bottom portion 210.

The module cover 200 may form a first short side 200SS1, a first long side 200LS1, a second short side 200SS2, and a second long side 200LS2. The first short side 200SS1, the first long side 200LS1, the second short side 200SS2 and the second long side 200LS2 of the module cover 200 can form a circumference of the module cover 200.

The first short side 200SS1, the first long side 200LS1, the second short side 200SS2 and the second long side 200LS2 of the module cover 200 may be corresponding to the first short side SS1, the first long side LS1, the second short side SS2, and the second long side LS2 of the display unit 20 (see FIG. 1), respectively.

The display panel 100 may form a first short side 100SS1, a first long side 100LS1, a second short side 100SS2 and a second long side 100LS2. The first short side 100SS1, the first long side 100LS1, the second short side 100SS2 and the second long side 100LS2 of the display panel 100 can form an outer circumference of the display panel 100.

The first short side 100SS 1 of the display panel 100 may be referred to as a first side 100SS1 of the display panel 100. The second short side 100SS2 of the display panel 100 may be referred to as the second side 100SS2 of the display panel 100. The first long side 100LS1 of the display panel 100 may be the third side 100LS1 of the display panel 100. The second long side 100LS2 of the display panel 100 may be regarded as the fourth side 100LS2 of the display panel 100.

The first short side 100SS1, the first long side 100LS1, the second short side 100SS2 and the second long side 100LS2 of the display panel 100 may be respectively corresponding to the first short side 200SS1, the first long side 200LS1, the second short side 200SS2, and the second long side 200LS2 of the module cover 200.

The length of the first short side 100SS1 of the display panel 100 may not be greater than the length of the first short side 200SS1 of the module cover 200. The length of the second short side 100SS2 of the display panel 100 may not be greater than the length of the second short side 200SS2 of the module cover 200. The length of the first long side 100LS1 of the display panel 100 may not be greater than the length of the first long side 200LS1 of the module cover 200. The length of the second long side 100LS2 of the display panel 100 may not be greater than the length of the second long side 200LS2 of the module cover 200.

The module cover 200 supports the display panel 100. The module cover 200 may have rigidity. The module cover 200 comprises a metal. In accordance with the claims, the module cover 200 includes aluminum.

The flat plate portion 210 of the module cover 200 may have a shape of a thin plate. The flat plate portion 210 may face the rear surface of the display panel 100. The flat plate portion 210 is coupled to the display panel 100. The flat plate portion 210 can support the display panel 100.

The side wall 220 of the module cover 200 may be disposed at the edges 200SS1, 200SS2, 200LS1, and 200LS2 of the module cover 200. The side wall 220 of the module cover 200 may be provided in plurality. The plurality of side walls 220 of the module cover 200 may face the edges 100SS1, 100SS2, 100LS1, and 100LS2 of the display panel 100.

The side wall 220 and the flat plate portion 210 of the module cover 200 may form a space opened toward the front of the module cover 200. The side wall 220 and the flat plate portion 210 of the module cover 200 may form a space capable of accommodating the display panel 100. The side wall 220 of the module cover 200 may have a shape that wraps or covers the display panel 100.

The display panel 100 may be positioned in front of the flat plate portion 210. The display panel 100 may be flexible. The display panel 100 may be provided with rigidity from the module cover 200. The display panel 100 may be housed in the module cover 200. The display panel 100 can display an image.

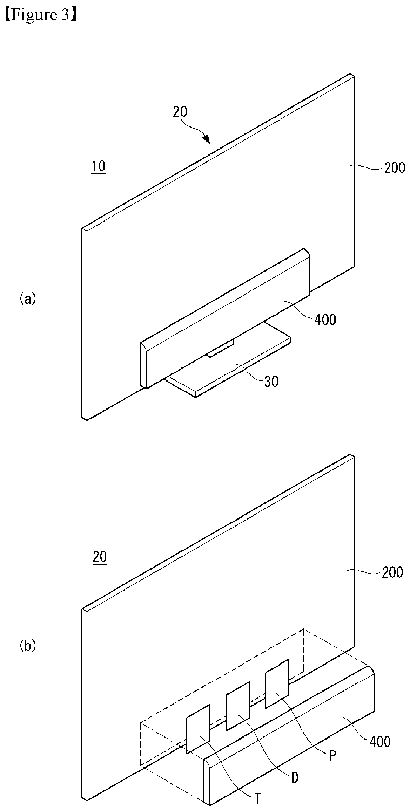

Referring to FIG. 3 (a), the display unit 20 may include a back cover 400. The back cover 400 may form a portion of the rear surface of the display unit 20. The back cover 400 may be located behind the module cover 200. For example, the back cover 400 may be disposed at a lower portion of the rear surface of the module cover 200. The back cover 400 may include a synthetic resin. The back cover 400 may be referred to as a PCB cover 400.

Referring to FIG. 3 (b), the display unit 20 may include a power supply board P, a driving board D, and a tuner board T. The power supply board P, the driving board D and the tuner board T may be located at the lower portion of the display unit 20. The power supply board P, the driving board D and the tuner board T can be covered by the back cover 400.

The power supply board P can be connected to an external power source. The power supply board P can rectify the AC power to the DC power. The power supply board P can provide the display unit 20 or the display panel 100 with electric power. For example, the power supply board P may provide DC power to the display unit 20 or the display panel 100.

The driving board D can control the display of the image of the display unit 20. The tuner board T can receive broadcast information or external input information. The tuner board T can provide the driving board D with the received broadcast information or external input information.

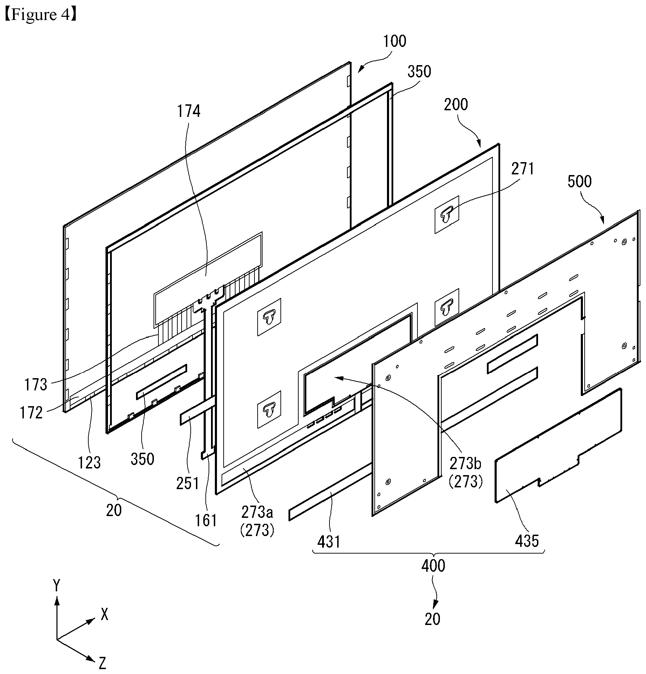

Referring to FIG. 4, the display device 10 may include a display unit 20 and a wall bracket 500. The display unit 20 includes a display panel 100, a module cover 200, and may include a PCB cover 400.

The display panel 100 may be positioned at the front side of the display unit 20. The display panel 100 may display an image or an image. The display panel 100 may include a plurality of pixels. The plurality of pixels can display an image by outputting RGB (red, green or blue). The display panel 100 may comprise an active area in which an image is displayed and a de-active area in which no image is displayed.

The display panel 100 may include an organic light emitting diode (OLED). The display panel 100 can emit light by itself. The display panel 110 may have a very small thickness.

At least one source PCB 172 and an interface PCB 174 may be disposed on the back side of the display panel 100. The interface PCB 174 may be spaced apart from the at least one source PCB 172. At least one source PCB 172 may be adj acent to the edge of the display panel 100 relative to the interface PCB 174. At least one source PCB 172 may be provided in plurality. The plurality of source PCBs 172 may be disposed apart from each other.

At least one PCB connector 173 may be disposed on the rear side of the display panel 100. The PCB connector 173 may electrically connect the interface PCB 174 and the source PCB 172.

The interface PCB 174 may mount wires for carrying digital video data and timing control signals transmitted from the outside of the display unit 20.

The source PCB 172 may electrically connect the interface PCB 174 and the display panel 100. The source COF (Chip On Film) 123 may connect the source PCB 172 and the display panel 100. The source COF 123 may extend from the edge of the display panel 100 to the source PCB 172. The source COF 123 may mount a data integrated circuit. The source COF 123 and the source PCB 172 may be integrally formed.

The adhesive sheet 350 may be positioned on the rear surface of the display panel 100. The adhesive sheet 350 may couple the display panel 100 and the module cover 200. The adhesive sheet 350 may be in the form of a rectangular photo-frame having a hollow portion. The adhesive sheet 350 may be positioned along the edges of the display panel 100.

The insulating sheet 251 may be positioned between the display panel 100 and the module cover 200. The insulating sheet 251 may be attached to the module cover 200. The insulating sheet 251 can protect the source PCB 172 from electromagnetic noise. The insulating sheet 251 may include an insulating material.

The module cover 200 may be provided on the rear surface of the display panel 100. The module cover 200 can be attached to the display panel 100 by the adhesive sheet 350. The module cover 200 can support the rear surface of the display panel 100. The module cover 200 may provide rigidity to the display panel 100. The module cover 200 may comprise a lightweight and highly rigid material. In accordance with the claims, the module cover 200 comprises aluminum.

The tilting hole 271 may be formed in the module cover 200. The tilting hole 271 can receive a hook formed on the wall bracket 500. The hook formed on the wall bracket 500 may have a shape of a protrusion.

The wall bracket 500 may be installed at a structure such as a wall. The display unit 20 can be supported on the wall bracket 500. For example, when the tilting hole 271 receives the hook formed in the wall bracket 500, the display unit 20 can be hanged on the wall bracket 500.

The opening 273 may be formed in the module cover 200. The opening 273 may include a first opening 273a and a second opening 273b.

The first opening 273a may correspond to the source PCB 172. For example, the first opening 273a may be adjacent to an edge of the module cover 200. The first opening 273a may receive the source PCB 172.

The second opening 273b may correspond to the interface PCB 174. For example, the second opening 273b may be located at the central portion of the module cover 200. The second opening 273b may receive the interface PCB 174.

The PCB cover 400 may be located behind the interface PCB 174 or behind the source PCB 172. The PCB cover 400 may include a first PCB cover 431 and a second PCB cover 435. The first PCB cover 431 may be located behind the source PCB 172. The second PCB cover 435 may be located behind the interface PCB 174. The first PCB cover 431 may cover the source PCB 172. The second PCB cover 435 may cover the interface PCB 174. The PCB cover 400 may include an insulating material. The PCB cover 400 may protect the source PCB 172 and the interface PCB 174 from leakage electric currents.

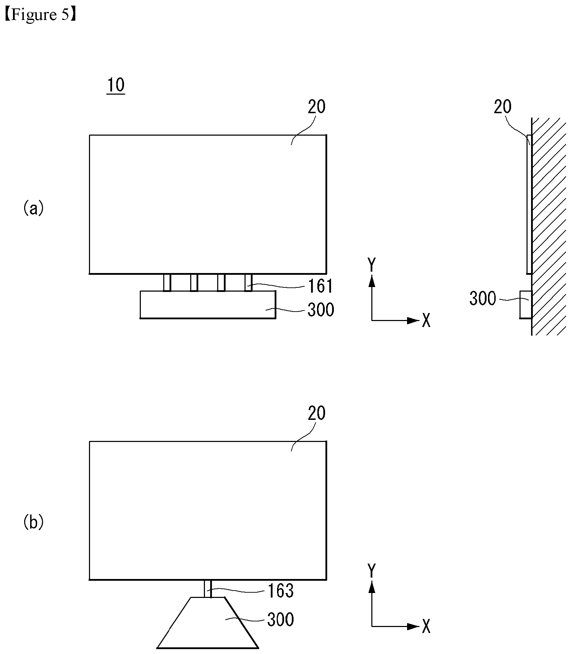

Referring to FIG. 5, the display device 10 includes a display unit 20 and may include a control unit 300. The control unit 300 may be electrically connected to the display unit 20.

The control unit 300 may provide signals and / or power to the display unit 20. The control unit 300 may include components that drive the display device 10. The case of the control unit may shield the components. For example, the case of the control unit 300 may shield at least one printed circuit board (PCB).

Referring to FIG. 5 (a), the display device 10 may include a cable 161. The cable 161 may be a flat cable 161. The flat cable 161 can electrically connect the display unit 20 and the control unit 300. A plurality of flat cables 161 may be provided.

Referring to FIG. 5 (b), the display device 10 may include a cable 163. The cable 163 may be a circular cable 163. The circular cable 163 may be thicker than the flat cable 161.

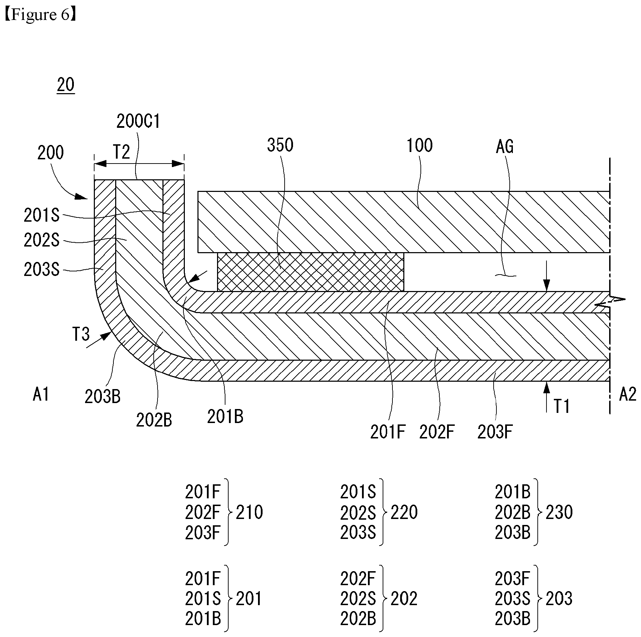

Referring to FIG. 6, the module cover 200 is positioned behind the display panel 100. The module cover 200 may face the rear surface of the display panel 100.

The adhesive sheet 350 may be positioned between the display panel 100 and the module cover 200. The adhesive sheet 350 can couple the display panel 100 with the module cover 200. The adhesive sheet 350 may be referred to as an adhesive tape 350. The adhesive sheet 350 may be, for example, a double-sided adhesive tape.

An air gap AG may be formed between the display panel 100 and the module cover 200. The air gap AG can receive fluid. For example, the air gap AG can receive air. The air gap AG may be a passage-way of the air. The air contained in the air gap AG can exchange heat with the display panel 100 and / or the module cover 200.

The module cover 200 includes a flat plate portion 210, a side wall 220, and a bent portion 230. The flat plate portion 210, the side wall 220, and the bent portion 230 may be integrally formed.

The flat plate portion 210 is positioned behind the display panel 100. The flat plate portion 210 may provide rigidity to the display panel 100. The flat plate portion 210 can support the display panel 100. The flat plate portion 210 can protect the rear surface of the display panel 100. The flat plate portion 210 may have a flat shape. The thickness of the flat plate portion 210 may be the first thickness T1. The flat plate portion 210 may be referred to as a bottom portion 210.

The side wall 220 is positioned forward with respect to the flat plate portion 210. The side wall 220 is extended from edges of the flat plate portion 210. The side wall 220 may be bent toward the front of the flat plate portion 210 from the edges of the flat plate portion 210. The side wall 220 may face a lateral side of the display panel 100. The lateral side of the display panel 100 may stand for at least one of an upper side, a lower side, a left side, and a right side of the display panel 100. The side wall 220 may face a lateral surface of the display panel 100. The lateral surface of the display panel 100 may stand for at least one of an upper surface, a lower surface, a left surface, and a right surface of the display panel 100. The side wall 220 can protect the lateral side or surface of the display panel 100. The side wall 220 may have a flat shape. The thickness of the side wall 220 may be the second thickness T2. The thickness of the side wall 220 may be substantially the same as the thickness of the flat plate portion 210. That is, the second thickness T2 may be substantially equal to the first thickness T1. For example, the second thickness T2 may be 1.0 mm to 1.2 mm.

The bent portion 230 is positioned between the flat plate portion 210 and the side wall 220. The bent portion 230 connects the flat plate portion 210 and the side wall 220. The bent portion 230 is extended from the flat plate portion 210 and is connected to the side wall 220. The bent portion 230 may have a curved shape. The bent portion 230 is bent toward the front of the flat plate portion 210 from an edge of the flat plate portion 210. The thickness of the bent portion 230 may be a third thickness T3. The third thickness T3 may be substantially the same as the second thickness T2.

The bent portion 230 may be formed by bending a edge portion of the flat plate portion 210. In this process, stress may be generated in the bent portion 230. The stress generated at the bent portion 230 may be related to the degree of bending of the bent portion 230. For example, the stress generated at the bent portion 230 may have a positive correlation with the bent degree of the bent portion 230. As the degree of bending of the bent portion 230 is greater, the bent portion 230 can be smaller.

The module cover 200 includes a plurality of layers. In accordance with the claims, the module cover 200 includes a first layer 201, a second layer 202, and a third layer 203. The heat expansion coefficient of the first layer 201 may be greater than the heat expansion coefficient of the second layer 202. The heat expansion coefficient of the third layer 203 may be substantially same as the heat expansion coefficient of the first layer 201.

The flat plate portion 210 includes a flat plate portion first layer 201F, a flat plate portion second layer 202F, and a flat plate portion third layer 203F. The side wall 220 may include a side wall first layer 201S, a side wall second layer 202S, and a side wall third layer 203S. The bent portion 230 may include a bent portion first layer 201B, a bent portion second layer 202B, and a bent portion third layer 203B.

The first layer 201 may be adjacent to the display panel 100. The third layer 203 may form a rear surface and a outer lateral surface of the display unit 20. The second layer 202 is located between the first layer 201 and the third layer 203. The first to third layers 201, 202, and 203 include a metal.

The first layer 201 faces the display panel 100. The first layer 201 may be exposed to outside air. The first layer 201 may include a material resistant to corrosion. The first layer 201 includes aluminum. For example, the first layer 201 may include an alloy of aluminum and manganese. The thickness of the first layer 201 may be 0.25 mm to 0.3 mm.

The first layer 201 may receive heat from the display panel 100. The first layer 201 may emit the heat of the display panel 100 to the outside. The first layer 201 may include a material having a high thermal conductivity. In accordance with the claims, the first layer 201 includes aluminum alloy.

The third layer 203 forms an appearance at the rear surface and may form the lateral surface of the display unit 20. Here, the lateral surface may stand for at least one of an upper surface, a lower surface, a left surface, and a right surface. The third layer 203 may be exposed to outside air. The third layer 203 may include a substance resistant to corrosion. The third layer 203 comprises aluminum. The material of the third layer 203 may be substantially the same as the material of the first layer 201. The thickness of the third layer 203 may be substantially equal to the thickness of the first layer 201. For example, the thickness of the third layer 203 may be 0.25 mm to 0.3 mm.

The second layer 202 is located between the first layer 201 and the third layer 203. The second layer 202 may couple the first layer 201 with the third layer 203. The second layer 202 is coupled to the first and third layers 201 and 203 by heat and / or pressure.

The second layer 202 may not be exposed to the outside except for the fracture surface 200C1. The second layer 202 may contribute to the rigidity of the module cover 200. For example, the second layer 202 may comprise a material having a high rigidity. In accordance with the claims, second layer 202 comprises stainless steel.

The first layer 201 includes the flat plate portion first layer 201F, may include the side wall first layer 201S, and may include the bent portion first layer 201B. The flat plate portion first layer 201F may face the display panel 100. The bent portion first layer 201B may be extended from the flat plate portion first layer 201F and be bent toward the front of the display panel 100. The side wall first layer 201S may be extended toward the front of the display panel 100 from the bent portion first layer 201B. The side wall first layer 201S may face a lateral surface or lateral side of the display panel 100.

The second layer 202 includes the flat plate portion second layer 202F, may include the side wall second layer 202S, and may include the bent portion second layer 202B. The flat plate portion second layer 202F may be positioned on the rear surface of the flat plate portion first layer 201F. The bent portion second layer 202B may be extended from the flat plate portion second layer 202F and be bent toward the front of the display panel 100. The side wall second layer 202S may be extended toward the front of the display panel 100 from the bent portion second layer 202B.

The third layer 203 includes the flat plate portion third layer 203F, may include the side wall third layer 203S, and may include the bent portion third layer 203B. The flat plate portion third layer 203F may be positioned on the rear surface of the flat plate portion second layer 202F. The flat plate portion third layer 203F may form the rear surface of the display unit 20. The bent portion third layer 203B may be extended from the flat plate portion third layer 203F and be bent toward the front of the display panel 100. The side wall third layer 203S may be extended toward the front of the display panel 100 from the bent portion third layer 203B. The side wall third layer 203 S can form a part of the outer appearance of the display unit 20. For example, the side wall third layer 203 S may form a left / right outer appearance and / or an upper / lower outer appearance of the display unit 20.

The side wall 220 may form a fracture surface 200C1. The fracture surface 200C1 can face the front of the display panel 100. The fracture surface 200C1 may have a flat shape. The fracture surface 200C1 may include a cross section of a first layer 201, a second layer 202, and a third layer 203. The fracture surface 200C1 can form an end of the side wall 220 and / or an end of the module cover 200.

The fracture surface 200C1 can be exposed to the outside air. A layer for preventing corrosion may be formed on the fracture surface 200C1. The layer for preventing corrosion may be transparent. The boundary between the fracture surface 200C1 and the outer surface can be angulated. The angulated boundary of the fracture surface 200C1 may have a problem for safety.

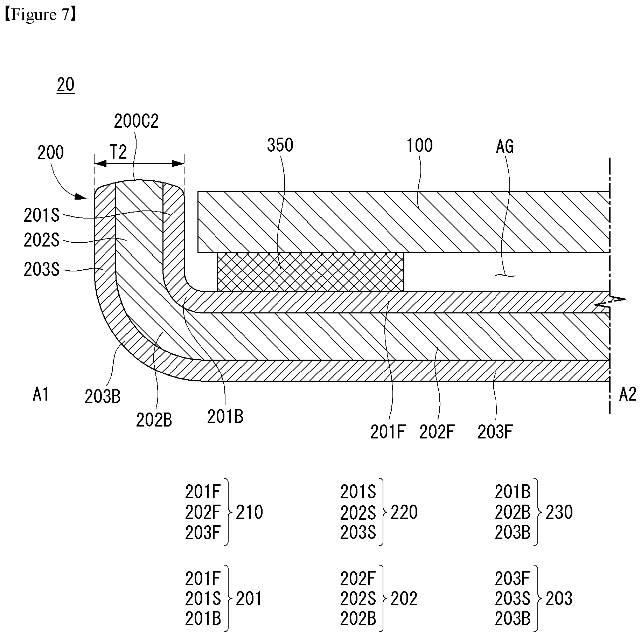

Referring to FIG. 7, the side walls 220 may form the treated surface 200C2. The treated surface 200C2 can be formed by processing the fracture surface 200C1 (see FIG. 6). The treated surface 200C2 can face the front of the display panel 100 as a whole. The treated surface 200C2 may be convex toward the front of the display panel 100. The boundary between the treated surface 200C2 and the outer surface can be rounded. The treated surface 200C2 may form an end of the side wall 220 and / or an end of the module cover 200.

The treatment of the fracture surface (200C1, see FIG. 6) may include chemical treatment, mechanical treatment, and optical treatment. The chemical treatment of the fracture surface (200C1, see FIG. 6) may refer to a process of cutting the fracture surface (200C1, see FIG. 6) using an etching solution or a radical. The chemical treatment of the fracture surface 200C1 (see FIG. 6) may include plasma processing. Plasma particles having high energy can cut or smooth or polish the fracture surface (200C1, see Fig. 6). The optical processing of the fracture surface 200C1 (see FIG. 6) may mean a process of cutting the fracture surface 200C1 (see FIG. 6) using a laser.

The mechanical treatment of the fracture surface 200C1 (see FIG. 6) may include a process of wearing out the fracture surface 200C1 (see FIG. 6) using a material having a rigidity higher than that of the module cover 200. For example, a blade made of a reinforced metal may wear the fracture surface 200C1 (see FIG. 6).

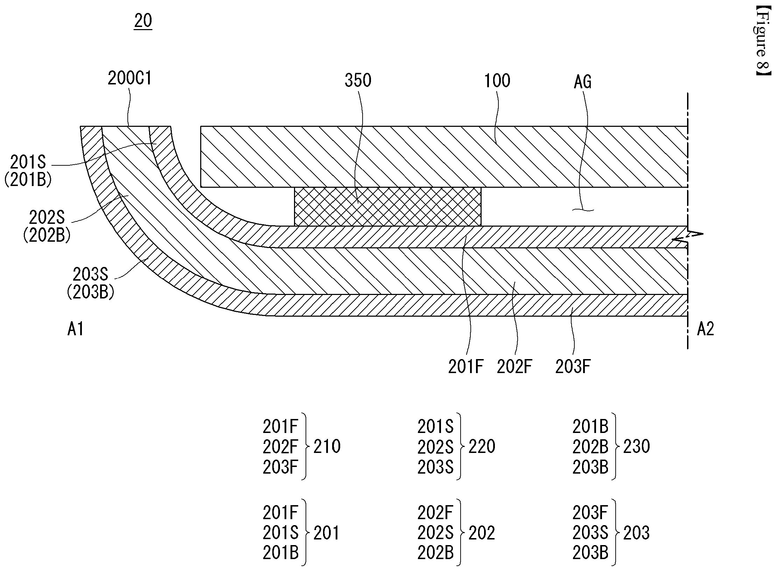

Referring to FIG. 8, the bent portion 230 may be extended from the flat plate portion 210 and be bent toward the front of the display panel 100. The bent portion 230 may face the lateral side or the lateral surface of the display panel 100. The lateral side (the lateral surface) of the display panel 100 may stand for the upper side (the upper surface), the lower side (the lower surface), the left side (the left surface), and the right side (the right surface) of the display panel 100. The bent portion 230 can protect the lateral side (lateral surface) of the display panel 100.

The bent portion 230 of the module cover 200 can be referred to as a side wall 220 of the module cover 200, with regard to the aspect that the bent portion 230 faces the lateral side of the display panel 100. The bent portion first layer 201B may be referred to as a side wall first layer 201S. The bent portion second layer 202B may be referred to as a side wall second layer 202S. The bent portion third layer 203B may be referred to as a side wall third layer 203S.

The bent portion 230 may form a fracture surface 200C1. The fracture surface 200C1 can face the front of the display panel 100. The fracture surface 200C1 may have a flat shape.

The degree of bending of the bent portion 230 can be described with FIG. 6. The bent portion shown in FIG. 6 may be positioned between the flat plate portion 210 and the side wall 220. The bent portion 230 shown in FIG. 6 may have a relatively small radius of curvature. The bent portion 230 shown in FIG. 6 may have a relatively large curvature. The degree of bending of the bent portion 230 shown in FIG. 6 may be relatively large. The bent portion 230 shown in FIG. 6 can have a relatively large stress.

The bent portion 230 shown in FIG. 8 may face a lateral side (or lateral surface) of the display panel 100. The bent portion 230 shown in FIG. 8 may have a relatively large radius of curvature. The bent portion 230 shown in FIG. 8 may have a relatively small curvature. The degree of bending of the bent portion 230 shown in FIG. 8 may be relatively small. The bent portion 230 shown in FIG. 8 may have a relatively small stress. The bent portion 230 shown in FIG. 8 may have relatively high resistance to external impact.

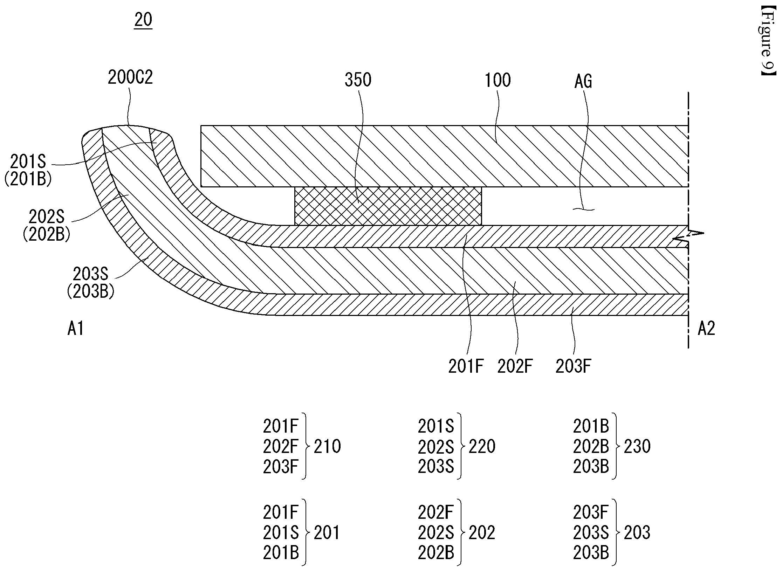

Referring to FIG. 9, the bent portion 230 may form the treated surface 200C2. The treated surface 200C2 can be formed by treating the fracture surface 200C1 (see FIG. 8). The treated surface 200C2 can face the front of the display panel 100 as a whole. The treated surface 200C2 shown in FIG. 9 may have substantially the same properties as the treated surface 200C2 shown in FIG. 7.

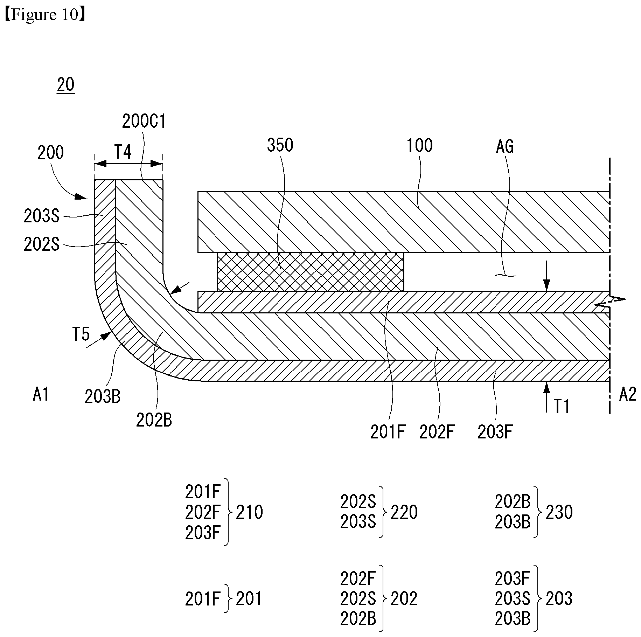

Referring to FIG. 10, the flat plate portion 210 and the side wall 220 may include a plurality of layers. The layer structure for forming the side wall 220 may be different from the layer structure for forming the flat plate portion 210. In accordance with the claims, the flat plate portion 210 has a layered structure of the first to third layers 201, 202, and 203. For example, the side wall 220 may have a layered structure of the second and third layers 202 and 203.

In accordance with the claims, the flat plate portion 210 includes a flat plate portion first layer 201F, a flat plate portion second layer 202F, and a flat plate portion third layer 203F. For example, the side wall 220 may include a side wall second layer 2025 and a side wall third layer 203S.

The thickness of the flat plate portion 210 may be referred to as a first thickness T1. The thickness of the side wall 220 may be the fourth thickness T4. The first thickness T1 may be greater than the fourth thickness T4. For example, the first thickness T1 may be 1.0 mm to 1.2 mm. For example, the fourth thickness T4 may be 0.75 mm to 0.9 mm. The thickness of the bent portion 230 may be the fifth thickness T5. The fifth thickness T5 may be substantially the same as the fourth thickness T4.

The thickness of the side wall 220 can be described in comparison with FIG. 6. The fourth thickness T4 may be smaller than the second thickness T2 (see FIG. 6). The thickness of the bezel of the display unit 20 according to the embodiment of the present invention shown in FIG. 10 may be smaller than the thickness of the bezel of the display unit 20 according to the embodiment of the present invention shown in FIG. 6. The visibility of the display unit 20 according to the embodiment of the present invention shown in FIG. 10 may be better than the visibility of the display unit 20 according to the embodiment of the present invention shown in FIG. 6.

The thickness of the bent portion 230 can be described in comparison with FIG. 6. The fifth thickness T5 may be smaller than the third thickness T3 (see FIG. 6). The stress formed in the bent portion 230 shown in FIG. 10 may be smaller than the stress formed in the bent portion 230 shown in FIG. 6. The durability of the module cover 200 according to the embodiment of the present invention shown in FIG. 10 may be higher than the durability of the module cover 200 according to the embodiment of the present invention shown in FIG. 6. The manufacturing of the bent portion 230 shown in FIG. 10 can be facilitated compared with the manufacturing of the bent portion 230 shown in FIG. 6.

The fracture surface 200C1 may be formed on the side wall 220. The fracture surface 200C1 can face the front of the display panel 100. The fracture surface 200C1 can be turned into treated surface 200C2 (see FIG. 7) through at least one of mechanical treatment, chemical treatment, and optical treatment. The properties of the fracture surface 200C1 shown in FIG. 10 may be similar to those of the fracture surface 200C1 shown in FIG. 6.

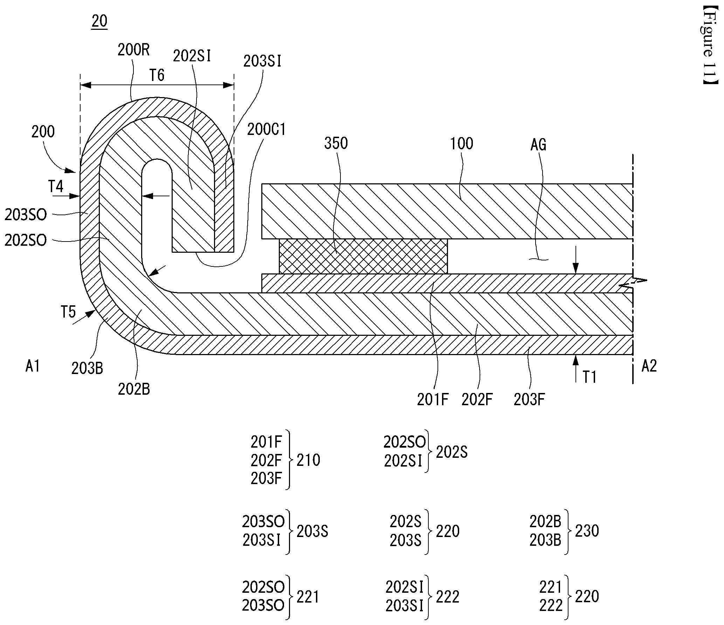

Referring to FIG. 11, the side wall 220 may include an outer side wall 221 and an inner side wall 222. The total thickness of the side wall 220 may be a sixth thickness T6. The side wall 220 is extended from the bent portion 230. The bent portion 230 is extended from the flat plate portion 210. As the side wall 220 includes the outer side wall 221 and the inner side wall 222, that the side wall 220 can stably protect the lateral side (lateral surface) of the display panel 100.

The flat plate portion 210 may be formed by stacking first to third layers 201, 202, and 203. The thickness of the flat plate portion 210 may be the first thickness T1. The bent portions 230 may be formed by stacking the second and third layers 202 and 203. The bent portion 230 may be formed by bending the flat plate portion 210 toward the front of the display panel 100. The thickness of the bent portion 230 may be a fifth thickness T5. The outer side wall 221 may be extended from the bent portion 230.

The outer side wall 221 may form an appearance of lateral side (lateral surface) of the display unit 20. The lateral side (lateral surface) of the display unit 20 may include at least one of an upper side (upper surface), a lower side (lower surface), a left side (left surface), and a right side (right surface) of the display unit 20. The outer side wall 221 may include an outer side wall second layer 202SO and an outer side wall third layer 203SO. The thickness of the outer side wall 221 may be a fourth thickness T4.

The inner side wall 222 may be extended from the outer side wall 221. The inner side wall 222 may include an inner side wall second layer 202SI and an inner side wall third layer 203 SI. The inner side wall second layer 202SI may be extended from the outer side wall second layer 202SO. The inner side wall third layer 203SI may be extended from the outer side wall third layer 203 SO.

The inner side wall 222 may be positioned between the outer side wall 221 and the display panel 100. The thickness of the inner side wall 222 may be substantially the same as the thickness of the outer side wall 221. For example, the thickness of the inner side wall 222 may be the fourth thickness T4.

The fracture surface 200C1 can form the end of the side wall 220 and / or the end of the module cover 200. The fracture surface 200C1 may face the flat plate portion 210 and / or the display panel 100. For example, the fracture surface 200C1 may face the flat plate portion 210. The inner side wall 222 may be directed to the rear of the display panel 100.

The side wall connection portion 200R may connect the inner side wall 222 and the outer side wall 221. The side wall connection portion 200R may be convex toward the front of the display panel 100. The side wall connection portion 200R may be a surface facing the front of the display panel 100 among the outer surface of the side wall 220. The side wall connection portion 200R may be a surface viewed from the front of the display panel 100 among the outer surface of the side wall 220. The side wall connection portion 200R may have a curved shape.

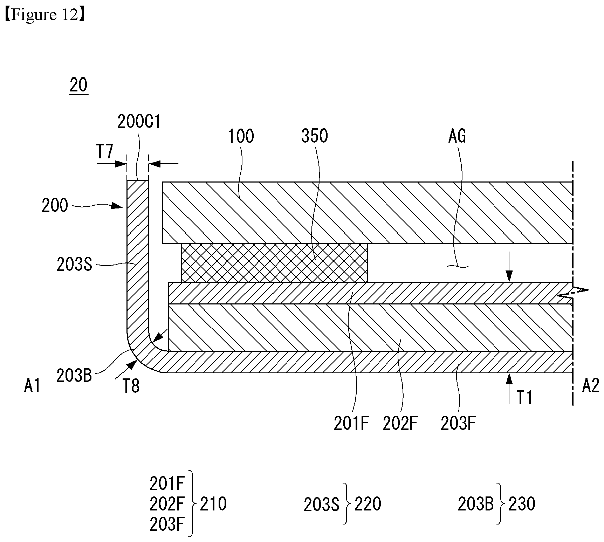

Referring to FIG. 12, the layer structure for forming the side wall 220 may be different from the layer structure for forming the flat plate portion 210. In accordance with the claims, the flat plate portion 210 has a multiple-layer structure. For example, the flat plate portion 210 may have a laminated structure (or layered structure) of the first to third layers 201, 202, and 203. For example, the side wall 220 may have a single layer structure.

The thickness of the flat plate portion 210 may be the first thickness T1. The flat plate portion 210 includes the flat plate portion first layer 201F, the flat plate portion second layer 202F, and the flat plate portion third layer 203F.

The bent portion 230 may be formed by bending the flat plate portion 210 toward the front of the display panel 100. The bent portion 230 may have a single layer structure. For example, the bent portion 230 may include the bent portion third layer 203B. The bent portion 230 may be extended from the flat plate portion third layer 203F.

The side wall 220 is extended from the bent portion 230. The side wall 220 may include a side wall third layer 203S. The side wall 220 may be extended from the bent portion third layer 203B. The thickness of the side wall 230 may be a seventh thickness T7. The seventh thickness T7 may be substantially equal to a eighth thickness T8. For example, the seventh thickness T7 may be 0.25 mm to 0.3 mm. The thickness of the bezel of the display unit 20 according to the embodiment of the present invention shown in FIG. 12 may be smaller than the thickness of the bezel of the display unit 20 according to the embodiment of the present invention shown in FIG. 10. The visibility of the display unit 20 according to the embodiment of the present invention shown in FIG. 12 may be better than the visibility of the display unit 20 according to the embodiment of the present invention shown in FIG. 10.

The thickness of the bent portion 230 can be described in comparison with FIG. 10. The thickness of the bent portion 230 may be the eighth thickness T8. The eighth thickness T8 may be substantially the same as the thickness of the third layer 203. For example, the eighth thickness T8 may be 0.25 mm to 0.3 mm. The eighth thickness T8 may be smaller than the fifth thickness T5 (see FIG. 10). The stress formed in the bent portion 230 shown in FIG. 12 may be smaller than the stress formed in the bent portion 230 shown in FIG. 10. The durability of the module cover 200 according to the embodiment of the present invention shown in FIG. 12 may be higher than the durability of the module cover 200 according to the embodiment of the present invention shown in FIG. 10. The manufacturing of the bent portion 230 shown in FIG. 12 can be facilitated in comparison with the manufacturing of the bent portion 230 shown in FIG. 10.

The fracture surface 200C1 may be formed at the side wall 220. The fracture surface 200C1 can face the front of the display panel 100. The fracture surface 200C1 can be processed to become the treated surface 200C2 (see FIG. 7). The properties of the fracture surface 200C1 shown in FIG. 12 may be similar to those of the fracture surface 200C1 shown in FIG. 10.

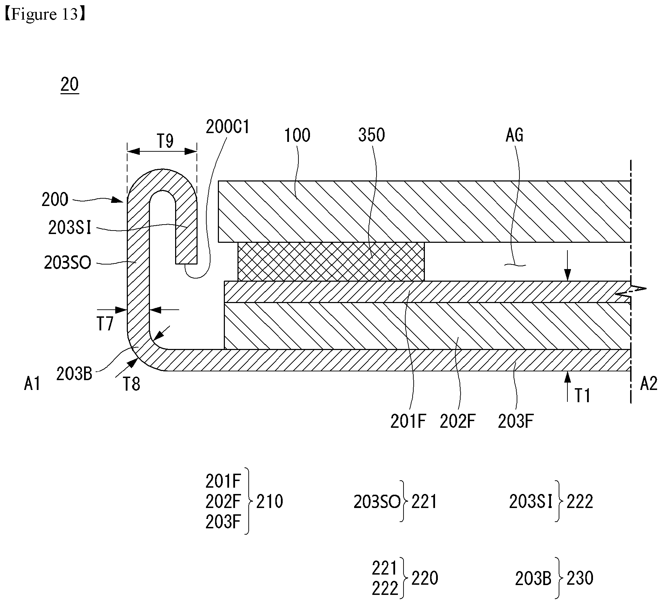

Referring to FIG. 13, the side wall 220 may include an outer side wall 221 and an inner side wall 222. The inner side wall 222 may be extended from the outer side wall 221. The inner side wall 222 may be positioned between the outer side wall 221 and the display panel 100. As the side wall 220 includes the outer side wall 221 and the inner side wall 222, the side wall 220 can stably protect the lateral side (or lateral surface) of the display panel 100.

The total thickness of the side wall 220 may be a ninth thickness T9. The total thickness of the side wall 220 may correspond to the sum of the thickness of the outer side wall 221 and the thickness of the inner side wall 222. The thickness of the outer side wall 221 may be a seventh thickness T7. The thickness of the inner side wall 222 may be substantially the same as the thickness of the outer side wall 221. The thickness of the inner side wall 222 may be the seventh thickness T7. The ninth thickness T9 may be greater than twice the seventh thickness T7. For example, the ninth thickness T9 may be 0.8 mm to 0.9 mm.

The side wall 220 shown in FIG. 13 can be compared to the side wall 220 shown in FIG. 6. The thickness of the side wall 220 shown in FIG. 6 may be 1.0 mm to 1.2 mm as the second thickness T2. The total thickness of the side wall 220 shown in FIG. 13 may be 0.8 mm to 0.9 mm as the ninth thickness T9. The side wall 220 shown in FIG. 13 can have a thin thickness compared to the side wall 220 shown in FIG. 6 while stably protecting the display panel 100.

The bent portion 230 shown in FIG. 13 can be compared with the bent portion 230 shown in FIG. 11. The thickness of the bent portion 230 shown in FIG. 13 may be 0.25 mm to 0.3 mm as the eighth thickness T8. The thickness of the bent portion 230 shown in FIG. 11 may be 0.75 mm to 0.9 mm as the fifth thickness T5.

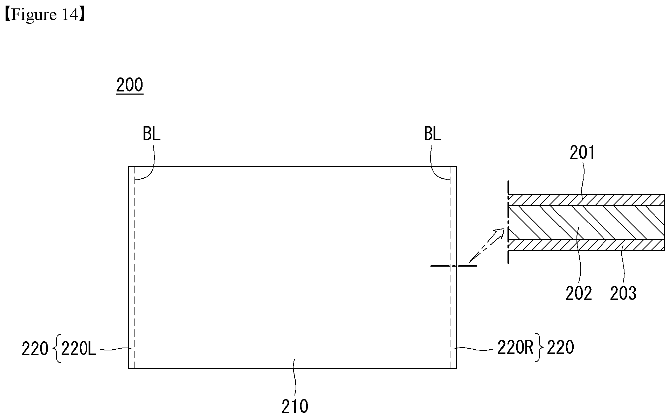

Referring to FIG. 14, a front surface of the module cover 200 according to an embodiment of the present invention can be observed. The module cover 200 is formed by stacking a plurality of metal layers. In accordance with the claims, the module cover 200 is formed by stacking first to third layers 201, 202, and 203. The module cover 200 can be manufactured by machining a metal plate. The metal plate may be formed by stacking a plurality of metal layers. The module cover 200 shown in FIG. 14 may be a flat metal plate.

The dotted line BL shown in FIG. 14 can indicate a part to be processed. For example, the dotted line BL shown in FIG. 14 may indicate the portion to be bent. The dotted line BL shown in FIG. 14 can be referred to as a bending line. The module cover 200 includes a flat plate portion 210 and a side wall 220. The side walls 220 may be provided in plural. For example, the side wall 220 may include a left side wall 220L and a right side wall 220R. The right side wall 220R may be referred to as a first side wall 220R. The left side wall 220L may be referred to as a second side wall 220L.

The left side wall 220L may be extended from the left side of the flat plate portion 210. The right side wall 220R may be extended from the right side of the flat plate portion 210. In a state before the bending process, the flat plate portion 210 may be positioned between the left side wall 220L and the right side wall 220R. The right side (or right edge) of the flat plate portion 210 may be opposite to the left side (or left edge) of the flat plate portion 210.

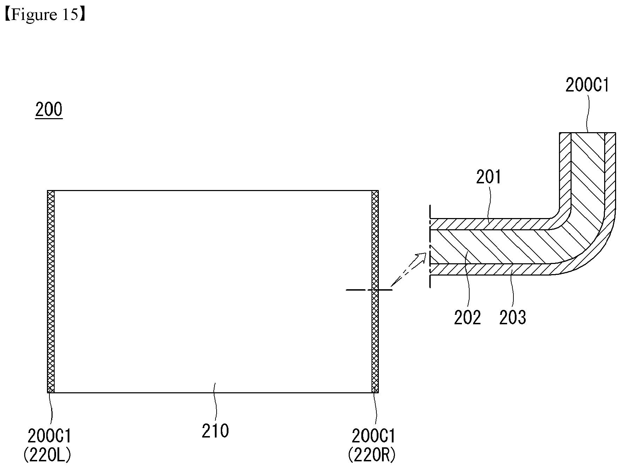

Referring to FIG. 15, a front surface of a flat plate portion 210 of a module cover 200 according to an embodiment of the present invention can be observed. As the left side wall 220L and the right side wall 220R shown in FIG. 14 are bent toward the front of the flat plate portion 210, the fracture surface 200C1 of the side wall 220 can be observed. The fracture surface 200C1 of the side wall 220 can face the front of the flat plate portion 210.

The module cover 200 can form an internal space. The internal space formed at the module cover 200 may be for accommodation. For example, the side wall 220 and the flat plate portion 210 can form the internal space. The internal space formed by the flat plate portion 210, the left side wall 220L and the right side wall 220R can be opened forward, upward, and downward of the flat plate portion 210. The display panel 100 (see FIG. 2) may be located in the internal space formed at the module cover 200.

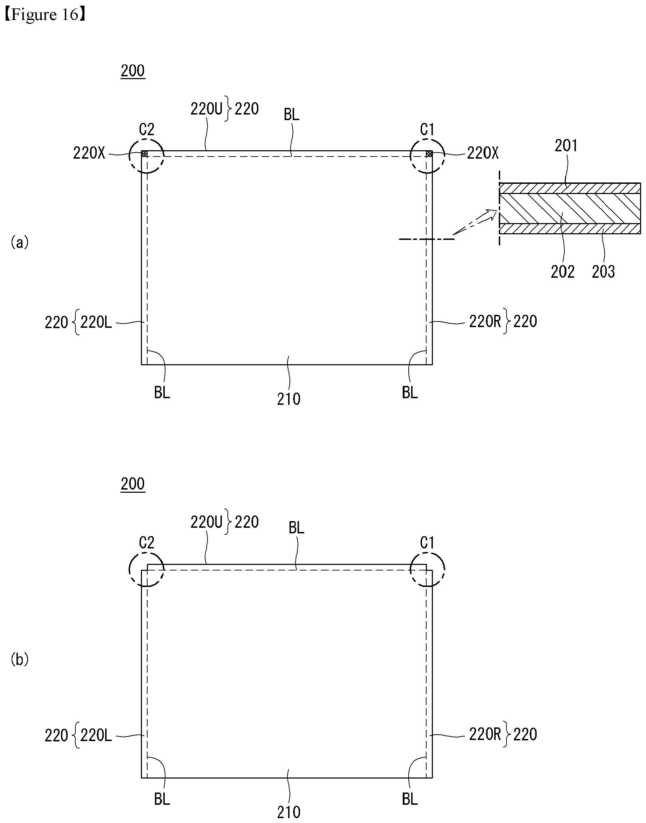

Referring to FIG. 16 (a), a front surface of the module cover 200 according to an embodiment of the present invention can be observed. The module cover 200 can be manufactured by processing a metal plate formed by stacking the first to third layers 201, 202, and 203. The module cover 200 shown in FIG. 16 may be a flat metal plate.

The dotted line BL shown in FIG. 16 may indicate the portion to be bent. The dotted line BL shown in FIG. 16 can be referred to as a bending line. The module cover 200 includes a flat plate portion 210 and a side wall 220. The side walls 220 may be provided in plural. For example, the side wall 220 may include a left side wall 220L, a right side wall 220R, and an upper side wall 220U. The upper side wall 220U may be referred to as a third side wall 220U.

The left side wall 220L may be extended from the left side of the flat plate portion 210. The right side wall 220R may be extended from the right side of the flat plate portion 210. The upper side wall 220U may be extended from the upper side of the flat plate portion 210. The upper edge of the flat plate portion 210 can connect the left edge and the right edge of the flat plate portion 210. An area around the point where the upper edge and the right edge of the flat plate portion 210 meet may be referred to as a first corner C1. An area around the point where the upper edge and the left edge of the flat plate portion 210 meet may be referred to as a second corner C2.

At the first corner C1 and the second corner C2, the overlapping areas 220X of the side wall 220 can be formed. The overlapping area 220X can be formed, as a bending line BL meets another bending line BL. The overlapping area 220X of the side wall 220 may be overfolded through bending process. Referring to FIG. 16 (b), the overlapping area 220X of the side wall 220 can be cut.

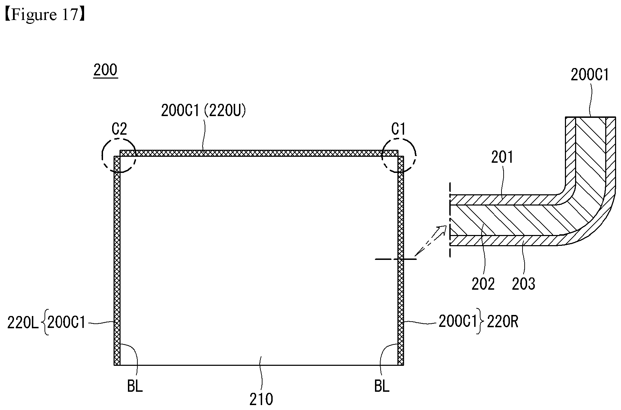

Referring to FIG. 17, a front surface of the flat plate portion 210 of the module cover 200 according to an embodiment of the present invention can be observed. As the side wall 220 shown in FIG. 16 is bent toward the front of the flat plate portion 210, the fracture surface 200C1 of the side wall 220 can be observed. The fracture surface 200C1 of the side wall 220 can face the front of the flat plate portion 210. The profile of the fracture surface 200C1 of the side wall 220 can be relatively uniform, as the overlapping areas 220X (see FIG. 16) has been removed.

The module cover 200 can form an internal space. For example, the side wall 220 and the flat plate portion 210 can form the internal space. The internal space formed by the flat plate portion 210, the left side wall 220L, the right side wall 220R and the upper side wall 220U can be opened forward and the downward of the flat plate portion 210. The display panel 100 (see FIG. 2) may be located in the internal space formed in the module cover 200.

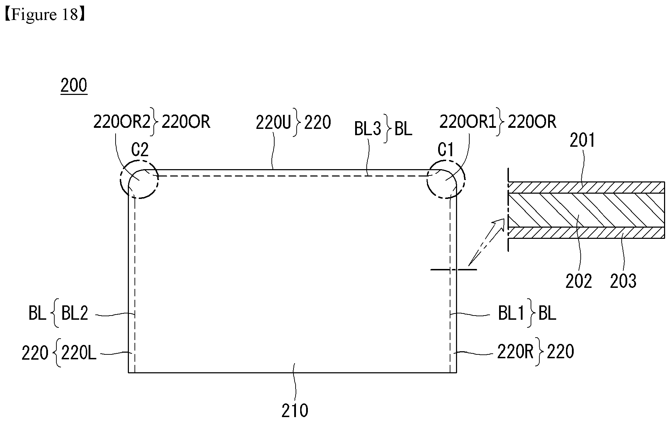

Referring to FIG. 18, a front surface of the module cover 200 according to an embodiment of the present invention can be observed. The module cover 200 can be manufactured by processing a metal plate formed by stacking the first to third layers 201, 202, and 203. The module cover 200 shown in FIG. 18 may be a flat metal plate.

The dotted line BL shown in FIG. 18 can be referred to as a bending line BL. The bending lines BL shown in FIG. 18 may be formed in plural. For example, the bending line BL may include a first bending line BL1, a second bending line BL2, and a third bending line BL3.

Referring to FIG. 18, a plurality of bending lines BL may not intersect with each other. The bending lines BL can reach the edges of the module cover 200 at the corners C1 and C2 or at positions adjacent to the corners C1 and C2. Such a structure of the plurality of bending lines BL can prevent overfolding of the overlapping area 220X (see FIG. 16) of the side wall 220.

A first bending line BL1 may be located alongside of the right edge of the module cover 200. A second bending line BL2 may be located alongside of the left edge of the module cover 200. A third bending line BL3 may be located alongside of the upper edge of the module cover 200. The first bending line BL1 and the third bent line BL3 can be adjacent to each other at the first corner C1. The first open region 220OR1 may be formed at the first corner C1. The first open region 220OR1 may be located between the first bending line BL1 and the third bending line BL3. The first open region 220OR1 may lead to the outer boundary of the flat plate portion 210. The outer boundary of the flat plate portion 210 may stand for the outer edge of the flat plate portion 210.

The second bending line BL 2 and the third bending line BL 3 may be adjacent to each other at the second corner C 2. The second open region 220OR2 may be formed at the second corner C2. The second open region 220OR2 can be located between the second bending line BL2 and the third bending line BL3. The second open region 220OR2 may lead to the outer boundary of the flat plate portion 210. The open region 220OR may represent at least one of the first open region 220OR1 and the second open region 220OR2.

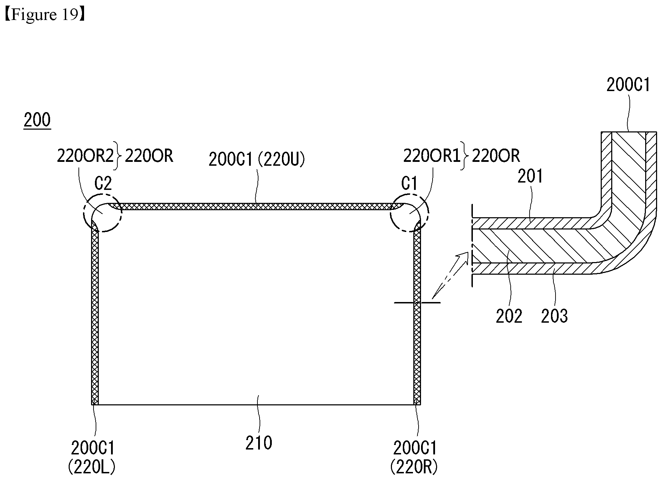

Referring to FIG. 19, a front surface of a flat plate portion 210 of a module cover 200 according to an embodiment of the present invention can be observed. As the side wall 220 shown in FIG. 18 is bent toward the front of the flat plate portion 210, the fracture surface 200C1 of the side wall 220 can be observed. The profile of the fracture surface 200C1 of the side wall 220 may not be uniform. The fracture surface 200C1 of the side wall 220 may be narrower as it goes to the corners C1 or C2.

The first open region 220OR1 may be formed at the first corner C1. The first open region 220OR1 may be formed between the right side wall 220R and the upper side wall 220U. The first open region 220OR1 and the flat plate portion 210 may share the same plane.

The second open region 220OR2 may be formed at the second corner C2. The second open region 220OR2 may be formed between the left side wall 220L and the upper side wall 220U. The second open region 220OR2 and the flat plate portion 210 may share the same plane.

The module cover 200 can form an internal space. The internal space formed by the flat plate portion 210, the left side wall 220L, the right side wall 220R and the upper side wall 220U can be opened downward of the flat plate portion 210. The internal space formed by the module cover 200 can communicate with the outside through the open region 220OR. The display panel 100 (see FIG. 2) may be located in the internal space formed in the module cover 200. The open region 220OR may be opened toward an outside of the flat plate portion 210 in a lateral direction. The lateral direction may include left direction, right direction, upper direction, and lower direction.

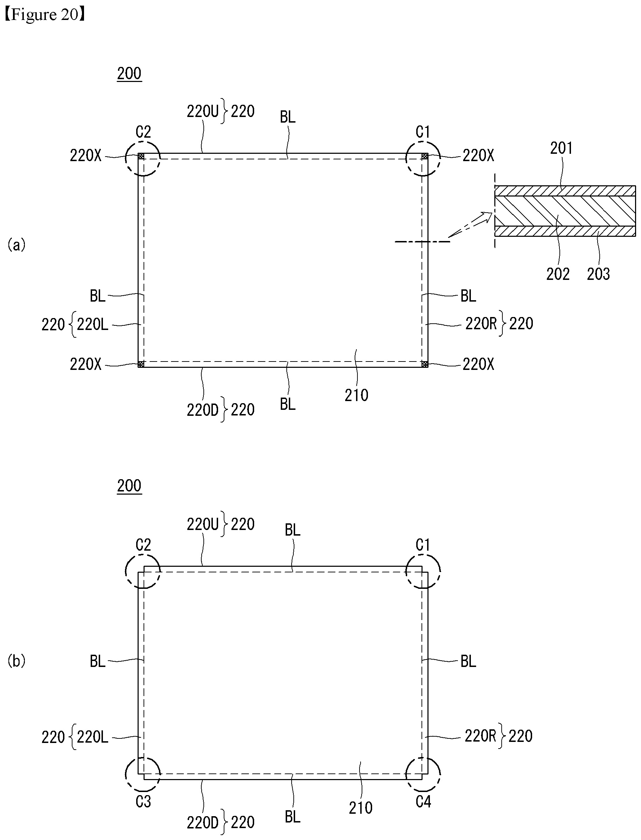

FIG. 20 can be explained in comparison with FIG. 16. The module cover 200 shown in FIG. 20 may be a flat metal plate. The module cover 200 may be formed by stacking first to third layers 201, 202, and 203.

Referring to FIG. 20 (a), the module cover 200 may include a plurality of side walls 220. For example, the side wall 220 may include a left side wall 220L, a right side wall 220R, an upper side wall 220U, and a lower side wall 220D. The lower side wall 220D may be referred to as a fourth side wall 220D.

The left side wall 220L may be extended from the left side of the flat plate portion 210. The right side wall 220L may be extended from the right side of the flat plate portion 210. The upper side wall 220U may be extended from the upper side of the flat plate portion 210. The lower side wall 220D may be extended from the lower side of the flat plate portion 210.

The upper edge of the flat plate portion 210 can connect the left edge and the right edge of the flat plate portion 210. A region adjacent to the point where the upper edge and the right edge of the flat plate portion 210 meet may be referred to as a first corner C1. A region adjacent to the point where the upper edge and the left edge of the flat plate portion 210 meet may be referred to as a second corner C2.

The lower edge of the flat plate portion 210 may be located opposite to the upper edge of the flat plate portion 210. The lower edge of the flat plate portion 210 can connect the left edge and the right edge of the flat plate portion 210. The region adjacent to the point where the lower edge and the left edge of the flat plate portion 210 meet may be referred to as a third corner C3. The region adjacent to the point where the lower edge and the right edge of the flat plate portion 210 meet may be referred to as a fourth corner C4.

Overlapping areas 220X of the side wall 220 can be formed at the first to fourth corners C1 to C4. The overlapping areas 220X can be formed as a bending line BL meets another bending line BL. The overlapping area 220X of the side wall 220 may be overfolded through bending process. Referring to FIG. 20 (b), the overlapping areas 220X of the side wall 220 can be cut.

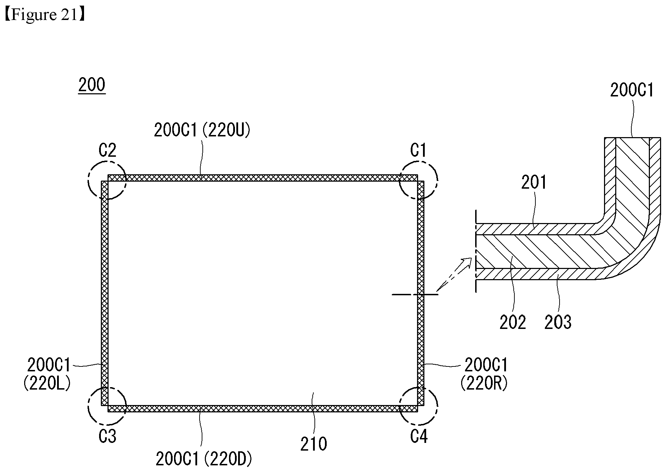

FIG. 21 can be explained in comparison with FIG. 17. Referring to FIG. 21, a front surface of the flat plate portion 210 of the module cover 200 according to an embodiment of the present invention can be observed. As the side wall 220 shown in FIG. 20 is bent toward the front of the flat plate portion 210, the fracture surface 200C1 of the side wall 220 can be observed. The fracture surface 200C1 of the side wall 220 can face the front of the flat plate portion 210.

The module cover 200 can form an internal space. For example, the side wall 220 and the flat plate portion 210 can form the internal space. The internal space formed by the flat plate portion 210, the left side wall 220L, the right side wall 220R, the upper side wall 220U and the lower side wall 220D can be opened forward of the flat plate portion 210. The display panel 100 (see FIG. 2) may be located in the internal space formed at the module cover 200.

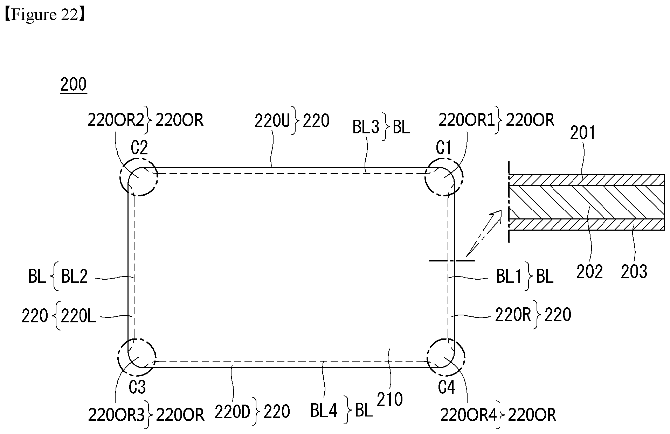

FIG. 22 can be explained in comparison with FIG. 18. Referring to FIG. 22, a front surface of the module cover 200 according to an embodiment of the present invention can be observed. The module cover 200 can be manufactured by processing a metal plate formed by stacking the first to third layers 201, 202, and 203. The module cover 200 shown in FIG. 22 may be a flat metal plate.

The dotted line BL shown in FIG. 22 can be referred to as a bending line BL. The bending lines BL shown in FIG. 18 may be formed in a plural. For example, the bending line BL may include a first bending line BL1, a second bending line BL2, a third bending line BL3, and a fourth bending line BL4. The first bending line BL1 may be formed alongside of the right edge of the module cover 200. The second bending line BL2 may be formed alongside of the left edge of the module cover 200. The third bending line BL3 may be formed alongside of the upper edge of the module cover 200. The fourth bending line BL4 may be formed alongside of the lower edge of the module cover 200.

Referring to FIG. 22, a plurality of bending lines BL may not intersect with each other. The bending lines BL can reach the edges of the module cover 200 at the corner C1 to C4 or at a position adjacent to the corner C1 to C4. Such a structure of the plurality of bent lines BL can prevent overfolding of the overlapping area 220X of the side wall 220 (see FIG. 20).

The first bending line BL1 and the third bending line BL3 may be adjacent to each other at the first corner C1. The first open region 220OR1 may be formed at the first corner C1. The first open region 220OR1 may be located between the first bending line BL1 and the third bending line BL3.

The second bending line BL2 and the third bending line BL3 may be adjacent to each other at the second corner C2. The second open region 220OR2 may be formed at the second corner C2. The second open region 220OR2 can be located between the second bending line BL2 and the third bending line BL3.

The second bending line BL2 and the fourth bending line BL4 may be adjacent to each other at the third corner C3. The third open region 220OR3 may be formed at the third corner C3. The third open region 220OR3 may be located between the second bending line BL2 and the fourth bending line BL4. The third open region 220OR3 may lead to the outer boundary of the flat plate portion 210.

The first bending line BL1 and the fourth bending line BL4 may be adjacent to each other at the fourth corner C4. The fourth open region 220OR4 may be formed at the fourth corner C4. The fourth open region 220OR4 may be located between the first bending line BL1 and the fourth bending line BL4. The fourth open region 220OR4 may lead to the outer boundary of the flat plate portion 210.

The open region 220OR may represent at least one of the first open region 220OR1, the second region area 220OR2, the third open region 220OR3, and the fourth open region 220OR4.

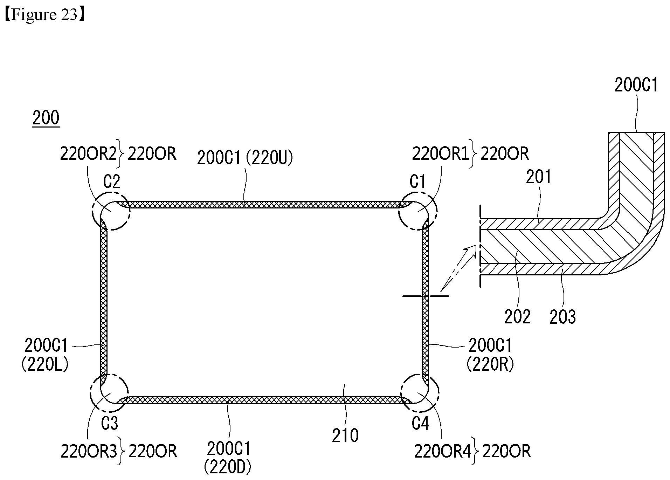

FIG. 23 can be explained in comparison with FIG. 19. Referring to FIG. 23, a front surface of the flat plate portion 210 of the module cover 200 according to an embodiment of the present invention can be observed. As the side wall 220 shown in FIG. 22 is bent toward the front of the flat plate portion 210, the fracture surface 200C1 of the side wall 220 can be observed. The fracture surface 200C1 of the side wall 220 may stand for a lateral surface of the side wall 220.

The first open region 220OR1 may be formed at the first corner C1. The first open region 220OR1 may be formed between the right side wall 220R and the upper side wall 220U. The first open region 220OR1 and the flat plate portion 210 may share the same plane.

The second open region 220OR2 may be formed at the second corner C2. The second open region 220OR2 may be formed between the left side wall 220L and the upper side wall 220U. The second open region 220OR2 and the flat plate portion 210 may share the same plane.

The third open region 220OR3 may be formed at the third corner C3. The third open region 220OR3 may be formed between the left side wall 220L and the lower side wall 220D. The third open region 220OR3 and the flat plate portion 210 may share the same plane.

The fourth open region 220OR4 may be formed at the fourth corner C4. The fourth open region 220OR4 may be formed between the right side wall 220R and the lower side wall 220D. The fourth open region 220OR4 and the flat plate portion 210 may share the same plane.

The module cover 200 can form an internal space. The internal space formed by the flat plate portion 210, the left side wall 220L, the right side wall 220R, the upper side wall 220U and the lower side wall 220D may be opened forward of the flat plate portion 210. The internal space formed by the module cover 200 can communicate with the outside through the open region 220OR. The display panel 100 (see FIG. 2) may be located in the internal space formed at the module cover 200.

It will be apparent to those skilled in the art that the present invention may be embodied in other specific forms without departing from the features of the independent claim.

Certain embodiments or other embodiments of the invention described above are not mutually exclusive or distinct from each other. Any or all elements of the embodiments of the invention described above may be combined or combined with each other in configuration or function.

The foregoing embodiments are merely examples and are not to be considered as limiting the present disclosure. The present teachings can be readily applied to other types of methods and apparatuses. The features, structures, methods, and other characteristics of the embodiments described herein may be combined in various ways to obtain additional and/or alternative embodiments.

## Claims

1. A display device (10) comprising a display unit (20) comprising:
a display panel (100); and
a module cover (200) supporting the display panel (100) and positioned at a rear of the display panel (100), the module cover (200) including:
a flat plate portion (210) to which the display panel (100) is coupled and having a flat surface;
a side wall (220) extended toward a front of the display panel (100) from the flat plate portion (210), the side wall (220) covering an edge of the display panel (100); and
a bent portion (230) bent toward the front of the flat plate portion (210) from an edge of the flat plate portion (210) to connect the flat plate portion (210) and the side wall (220),
wherein the side wall (220) includes:
a first side wall (220R) placed alongside of a first edge (100SS1) of the display panel (100); and
a second side wall (220L) placed alongside of a second edge (100SS2) of the display panel (100) opposite the first edge (100SS1) of the display panel (100),
wherein the bent portion (230) includes:
a first bent portion connecting the first side wall (220R) and the flat plate portion (210); and
a second bent portion connecting the second side wall (220L) and the flat plate portion (210),
the module cover (200) being formed from:
a first layer (201) faced with the display panel (100) and formed of aluminum alloy, a third layer (203) forming an appearance of the rear surface of the display unit (20) and comprising aluminum, and
a second layer (202) disposed between the first layer (201) and the third layer (203), coupled to the first and third layers (201, 203) by heat and/or pressure, and comprising stainless steel, such that the flat plate portion (210) includes:
a flat plate portion first layer (201F) formed by the first layer (201);
a flat plate portion second layer (202F) formed by the second layer (202); and
a flat plate portion third layer (203F) formed by the third layer (203).

2. The display device (10) of claim 1, wherein the side wall (220) includes:
a side wall second layer (202S) extended from the flat plate portion second layer (202F); and
a side wall third layer (203S) extended from the flat plate portion third layer (203F).

3. The display device (10) of claim 2, wherein the side wall (220) excludes a side wall layer extended from the flat portion first layer (201F).

4. The display device (10) of claim 1, wherein the side wall (220) includes:
a side wall first layer (201S) extended from the flat plate portion first layer (201F);
a side wall second layer (202S) extended from the flat plate portion second layer (202F); and
a side wall third layer (203S) extended from the flat plate portion third layer (203F).

5. The display device (10) of claim 1, wherein the side wall (220) includes:
an outer side wall (221) bent and extended toward the front of the display panel (100) from the flat plate portion (210); and
an inner side wall (222) extended from the outer side wall (221), the inner side wall (222) positioned between the outer side wall (221) and the display panel (100).

6. The display device (10) of claim 1, wherein the side wall (220) further includes a third side wall (220U) placed alongside of a third edge of the display panel (100) connecting the first edge and the second edge.

7. The display device (10) of claim 6, wherein the flat plate portion (210) further includes:
a first open region (220OR1) positioned between the first side wall (220R) and the third side wall (220U), the first open region (220OR1) leading to an outer boundary of the flat plate portion (210) and being opened toward an outside of the flat plate portion (210) in a lateral direction; and
a second open region (220OR2) positioned between the second side wall (220L) and the third side wall (220U), the second open region (220OR2) leading to the outer boundary of the flat plate portion (210) and being opened toward the outside of the flat plate portion (210) in the lateral direction.

8. The display device (10) of claim 6, wherein the side wall (220) further includes a fourth side wall (220D) placed alongside of a fourth edge of the display panel (100) opposite to the third edge of the display panel (100).

9. The display device (10) of claim 8, wherein the flat plate portion (210) further includes:
a first open region (220OR1) positioned between the first side wall (220R) and the third side wall (220U), the first open region (220OR1) leading to an outer boundary of the flat plate portion (210) and being opened toward an outside of the flat plate portion (210) in a lateral direction;
a second open region (220OR2) positioned between the second side wall (220L) and the third side wall (220U), the second open region (220OR2) leading to the outer boundary of the flat plate portion (210) and being opened toward the outside of the flat plate portion (210) in the lateral direction;
a third open region (220OR3) positioned between the second side wall (220L) and the fourth side wall (220D), the third open region (220OR3) leading to the outer boundary of the flat plate portion (210) and being opened toward the outside of the flat plate portion (210) in the lateral direction; and
a fourth open region (220OR4) positioned between the first side wall (220R) and the fourth side wall (220D), the fourth open region (220OR4) leading to the outer boundary of the flat plate portion (210) and being opened toward the outside of the flat plate portion (210) in the lateral direction.

10. The display device (10) of claim 1, wherein the material of the flat plate portion first layer (201F) is the same as the material of the flat plate portion third layer (203F).

11. The display device (10) of claim 10, wherein a heat expansion coefficient of the flat plate portion first layer (201F) is greater than a heat expansion coefficient of the flat plate portion second layer (202F).

12. The display device (10) of the claim 1, wherein the display panel (100) is attached to the module cover (200) by an adhesive sheet (350).

## Patentansprüche

1. Anzeigevorrichtung (10) mit einer Anzeigeeinheit (20), umfassend:
eine Anzeigetafel (100); und
eine Modulabdeckung (200), die die Anzeigetafel (100) trägt und an einer Rückseite der Anzeigetafel (100) angeordnet ist, wobei die Modulabdeckung (200) umfasst:
einen flachen Plattenabschnitt (210), mit dem die Anzeigetafel (100) verbunden ist und der eine flache Oberfläche aufweist;
eine Seitenwand (220), die sich von dem flachen Plattenabschnitt (210) zu einer Vorderseite der Anzeigetafel (100) erstreckt, wobei die Seitenwand (220) einen Rand der Anzeigetafel (100) abdeckt; und
einen gebogenen Abschnitt (230), der von einem Rand des flachen Plattenabschnitts (210) zur Vorderseite des flachen Plattenabschnitts (210) gebogen ist, um den flachen Plattenabschnitt (210) und die Seitenwand (220) zu verbinden,
wobei die Seitenwand (220) umfasst:
eine erste Seitenwand (220R), die entlang einer ersten Kante (100SS1) der Anzeigetafel (100) angeordnet ist; und
eine zweite Seitenwand (220L), die entlang einer zweiten Kante (100SS2) der Anzeigetafel (100) gegenüber der ersten Kante (100SS1) der Anzeigetafel (100) angeordnet ist,
wobei der gebogene Abschnitt (230) umfasst:
einen ersten gebogenen Abschnitt, der die erste Seitenwand (220R) und den flachen Plattenabschnitt (210) verbindet; und
einen zweiten gebogenen Abschnitt, der die zweite Seitenwand (220L) und den flachen Plattenabschnitt (210) verbindet,
die Modulabdeckung (200) wird gebildet aus:
einer ersten Schicht (201), die der Anzeigetafel (100) gegenüberliegt und aus einer Aluminiumlegierung besteht,
eine dritte Schicht (203), die das Aussehen der Rückseite der Anzeigeeinheit (20) bildet und Aluminium umfasst, und
eine zweite Schicht (202), die zwischen der ersten Schicht (201) und der dritten Schicht (203) angeordnet ist, durch Wärme und/oder Druck mit der ersten und der dritten Schicht (201, 203) verbunden ist und rostfreien Stahl umfasst,
so dass der flache Plattenabschnitt (210) umfasst:
eine erste Schicht (201F) des flachen Plattenabschnitts, die durch die erste Schicht (201) gebildet wird;
eine zweite Schicht (202F) des flachen Plattenabschnitts, die durch die zweite Schicht (202) gebildet wird; und
eine dritte Schicht (203F) des flachen Plattenabschnitts, die durch die dritte Schicht (203) gebildet wird.

2. Anzeigevorrichtung (10) nach Anspruch 1, wobei die Seitenwand (220) umfasst:
eine zweite Seitenwandschicht (202S), die sich von der zweiten Schicht (202F) des flachen Plattenabschnitts aus erstreckt; und
eine dritte Seitenwandschicht (203S), die sich von der dritten Schicht (203F) des flachen Plattenabschnitts aus erstreckt.

3. Anzeigevorrichtung (10) nach Anspruch 2, wobei die Seitenwand (220) eine Seitenwandschicht ausschließt, die sich von der ersten Schicht (201F) des flachen Abschnitts erstreckt.

4. Anzeigevorrichtung (10) nach Anspruch 1, wobei die Seitenwand (220) umfasst:
eine erste Seitenwandschicht (201S), die sich von der ersten Schicht des flachen Plattenabschnitts (201F) aus erstreckt;
eine zweite Seitenwandschicht (202S), die sich von der zweiten Schicht des flachen Plattenabschnitts (202F) aus erstreckt; und
eine dritte Seitenwandschicht (203S), die sich von der dritten Schicht des flachen Plattenabschnitts (203F) aus erstreckt.

5. Anzeigevorrichtung (10) nach Anspruch 1, wobei die Seitenwand (220) umfasst:
eine äußere Seitenwand (221), die gebogen ist und sich von dem flachen Plattenabschnitt (210) zu der Vorderseite der Anzeigetafel (100) erstreckt; und
eine innere Seitenwand (222), die sich von der äußeren Seitenwand (221) aus erstreckt, wobei die innere Seitenwand (222) zwischen der äußeren Seitenwand (221) und dem Anzeigefeld (100) angeordnet ist.

6. Anzeigevorrichtung (10) nach Anspruch 1, wobei die Seitenwand (220) ferner eine dritte Seitenwand (220U) umfasst, die entlang einer dritten Kante der Anzeigetafel (100) angeordnet ist und die erste Kante und die zweite Kante verbindet.

7. Anzeigevorrichtung (10) nach Anspruch 6, wobei der flache Plattenabschnitt (210) ferner umfasst:
einen ersten offenen Bereich (220OR1), der zwischen der ersten Seitenwand (220R) und der dritten Seitenwand (220U) angeordnet ist, wobei der erste offene Bereich (220OR1) zu einer äußeren Begrenzung des flachen Plattenabschnitts (210) führt und zu einer Außenseite des flachen Plattenabschnitts (210) in einer seitlichen Richtung geöffnet ist; und
einen zweiten offenen Bereich (220OR2), der zwischen der zweiten Seitenwand (220L) und der dritten Seitenwand (220U) positioniert ist, wobei der zweite offene Bereich (220OR2) zu der äußeren Begrenzung des flachen Plattenabschnitts (210) führt und zu der Außenseite des flachen Plattenabschnitts (210) in der seitlichen Richtung geöffnet ist.

8. Anzeigevorrichtung (10) nach Anspruch 6, wobei die Seitenwand (220) ferner eine vierte Seitenwand (220D) umfasst, die entlang einer vierten Kante der Anzeigetafel (100) gegenüber der dritten Kante der Anzeigetafel (100) angeordnet ist.

9. Anzeigevorrichtung (10) nach Anspruch 8, wobei der flache Plattenabschnitt (210) ferner umfasst:
einen ersten offenen Bereich (220OR1), der zwischen der ersten Seitenwand (220R) und der dritten Seitenwand (220U) angeordnet ist, wobei der erste offene Bereich (220OR1) zu einer äußeren Begrenzung des flachen Plattenabschnitts (210) führt und zu einer Außenseite des flachen Plattenabschnitts (210) in einer seitlichen Richtung geöffnet ist;
einen zweiten offenen Bereich (220OR2), der zwischen der zweiten Seitenwand (220L) und der dritten Seitenwand (220U) positioniert ist, wobei der zweite offene Bereich (220OR2) zu der äußeren Begrenzung des flachen Plattenabschnitts (210) führt und zu der Außenseite des flachen Plattenabschnitts (210) in der seitlichen Richtung geöffnet ist;
einen dritten offenen Bereich (220OR3), der zwischen der zweiten Seitenwand (220L) und der vierten Seitenwand (220D) angeordnet ist, wobei der dritte offene Bereich (220OR3) zu der äußeren Begrenzung des flachen Plattenabschnitts (210) führt und in der seitlichen Richtung zur Außenseite des flachen Plattenabschnitts (210) hin geöffnet ist; und
einen vierten offenen Bereich (220OR4), der zwischen der ersten Seitenwand (220R) und der vierten Seitenwand (220D) positioniert ist, wobei der vierte offene Bereich (220OR4) zur äußeren Begrenzung des flachen Plattenabschnitts (210) führt und zur Außenseite des flachen Plattenabschnitts (210) in der seitlichen Richtung geöffnet ist.

10. Anzeigevorrichtung (10) nach Anspruch 1, wobei das Material der ersten Schicht (201F) des flachen Plattenabschnitts das gleiche ist wie das Material der dritten Schicht (203F) des flachen Plattenabschnitts.

11. Anzeigevorrichtung (10) nach Anspruch 10, wobei ein Wärmeausdehnungskoeffizient der ersten Schicht (201F) des flachen Plattenabschnitts größer ist als ein Wärmeausdehnungskoeffizient der zweiten Schicht (202F) des flachen Plattenabschnitts.

12. Anzeigevorrichtung (10) nach Anspruch 1, wobei die Anzeigetafel (100) an der Modulabdeckung (200) durch eine Klebefolie (350) befestigt ist.

## Revendications

1. Dispositif d'affichage (100) comprenant une unité d'affichage (20) comprenant:
un panneau d'affichage (100); et
un couvercle de module (200) supportant l'écran d'affichage (100) et positionné à l'arrière de l'écran d'affichage (100), le couvercle de module (200) comportant:
une partie de plaque plate (210) à laquelle l'écran d'affichage (100) est accouplé et ayant une surface plate;
une paroi latérale (220) s'étendant en direction de l'avant de l'écran d'affichage (100) depuis la partie de plaque plate (210), la paroi latérale (220) recouvrant un bord de l'écran d'affichage (100); et
une partie pliée (230) pliée en direction de l'avant de la partie de plaque plate (210) depuis un bord de la partie de plaque plate (210) pour relier la partie de plaque plate (210) et la paroi latérale (220),
dans lequel la paroi latérale (220) comporte:
une première paroi latérale (220R) placée le long d'un premier bord (100SS1) de l'écran d'affichage (100); et
une seconde paroi latérale (220L) placée le long d'un second bord (100SS2) de l'écran d'affichage (100) en regard du premier bord (100SS1) de l'écran d'affichage (100),
dans lequel la paroi pliée (230) comporte:
une première partie pliée reliant la première paroi latérale (220R) et la partie de plaque plate (210); et
une seconde partie pliée reliant la seconde paroi latérale (220L) et la partie de plaque plate (210),
le couvercle de module (200) étant formé:
d'une première couche (201) faisant face à l'écran d'affichage (100) et formée d'alliage d'aluminium,
d'une troisième couche (203) formant une apparence de la surface arrière de l'unité d'affichage (20) et comprenant de l'aluminium, et
d'une deuxième couche (202) disposée entre la première couche (201) et la troisième couche (203), accouplée aux première et troisième couches (201, 203) par chauffage et/ou par pression, et comprenant de l'acier inoxydable,
de sorte que la partie de plaque plate (210) comporte:
une première couche de partie de plaque plate (201F) formée par la première couche (201);
une seconde couche de partie de plaque plate (202F) formée par la deuxième couche (202); et
une troisième couche de partie de plaque plate (203F) formée par la troisième couche (203).

2. Dispositif d'affichage (10) selon la revendication 1, dans lequel la paroi latérale (220) comporte:
une deuxième couche de paroi latérale (202S) s'étendant depuis la deuxième couche de partie plaque plate (202F); et
une troisième couche de paroi latérale (203S) s'étendant depuis la troisième couche de partie plaque plate (203F).

3. Dispositif d'affichage (10) selon la revendication 2, dans lequel la paroi latérale (220) exclut une couche de paroi latérale s'étendant depuis la première couche de partie plate (201F).

4. Dispositif d'affichage (10) selon la revendication 1, dans lequel la paroi latérale (220) comporte:
une première couche de paroi latérale (201S) s'étendant depuis la première couche de partie plaque plate (201F);
une deuxième couche de paroi latéral (202S) s'étendant depuis la deuxième couche de partie plaque plate (202F); et
une troisième couche de paroi latérale (203S) s'étendant depuis la troisième couche de partie plaque plate (203F).

5. Dispositif d'affichage (10) selon la revendication 1, dans lequel la paroi latérale (220) comporte:
une paroi latérale externe (221) pliée et s'étendant en direction de l'avant de l'écran d'affichage (100) depuis la partie de plaque plate (210); et
une paroi latérale interne (222) s'étendant depuis la paroi latérale externe (221), la paroi latérale interne (222) positionnée entre la paroi latérale externe (221) et l'écran d'affichage (100).

6. Dispositif d'affichage (10) selon la revendication 1, dans lequel la paroi latérale (220) comprend en outre une troisième paroi latérale (220U) placée le long d'un troisième bord de l'écran d'affichage (100) reliant le premier bord et le deuxième bord.

7. Dispositif d'affichage (10) selon la revendication 6, dans lequel la partie de plaque plate (210) comporte en outre:
une première région ouverte (220OR1) positionnée entre la première paroi latérale (220R) et le troisième paroi latérale (220U), la première région ouverte (220OR1) menant à une limite extérieure de la partie de plaque plate (210) et étant ouverte en direction de l'extérieur de la partie de plaque plate (210) dans une direction latérale; et
une deuxième région ouverte (220OR2) positionnée entre la deuxième paroi latérale (220L) et le troisième paroi latérale (220U), la deuxième région ouverte (220OR2) menant à une limite extérieure de la partie de plaque plate (210) et étant ouverte en direction de l'extérieur de la partie de plaque plate (210) dans une direction latérale.

8. Dispositif d'affichage (10) selon la revendication 6, dans lequel la paroi latérale (220) comporte en outre une quatrième paroi latérale (220D) placée le long d'un quatrième bord de l'écran d'affichage (100) en regard du troisième bord de l'écran d'affichage (100).

9. Dispositif d'affichage (10) selon la revendication 8, dans lequel la partie de plaque plate (210) comporte en outre:
une première région ouverte (220OR1) positionnée entre la première paroi latérale (220R) et la troisième paroi latérale (220U), la première région ouverte (220OR1) menant à une limite extérieure de la partie de plaque plate (210) et étant ouverte en direction de l'extérieur de la partie de plaque plate (210) dans une direction latérale;
une deuxième région ouverte (220OR2) positionnée entre la deuxième paroi latérale (220L) et la troisième paroi latérale (220U), la deuxième région ouverte (220OR2) menant à une limite extérieure de la partie de plaque plate (210) et étant ouverte en direction de l'extérieur de la partie de plaque plate (210) dans une direction latérale;
une troisième région ouverte (220OR3) positionnée entre la deuxième paroi latérale (220L) et la quatrième paroi latérale (220D), la troisième région ouverte (220OR3) menant à la limite extérieure de la partie de plaque plate (210) et étant ouverte en direction de l'extérieur de la partie de plaque plate (210) dans la direction latérale; et
une quatrième région ouverte (220OR4) positionnée entre la première paroi latérale (220R) et la quatrième paroi latérale (220D), la quatrième région ouverte (220OR4) menant à une limite extérieure de la partie de plaque plate (210) et étant ouverte en direction de l'extérieur de la partie de plaque plate (210) dans une direction latérale.

10. Dispositif d'affichage (10) selon la revendication 1, dans lequel le matériau de la première couche de partie de plaque plate (201F) est le même que le matériau de la troisième couche de partie de plaque plate (203F).

11. Dispositif d'affichage (10) selon la revendication 10, dans lequel un coefficient de dilatation thermique de la première couche de partie de plaque plate (201F) est supérieur à un coefficient de dilatation thermique de la deuxième couche de partie de plaque plate (202F).

12. Dispositif d'affichage (10) selon la revendication 1, dans lequel l'écran d'affichage (100) est fixé au couvercle de module (200) par une feuille adhésive (350).
